# EUROPEAN PATENT SPECIFICATION

(11) **EP 1 711 550 B1**
(45) Date of publication and mention of the grant of the patent: **01.12.2010**
(21) Application number: 04805194.0
(22) Date of filing: 23.12.2004
(51) Int. Cl.: C08G 77/02, C08G 77/20, C09D 183/04, H01L 21/31, C07F 7/18, C01B 33/12, C07C 53/138, C07C 57/28

(54) **ADAMANTYL MONOMERS AND POLYMERS FOR LOW-K-DIELECTRIC APPLICATIONS**
ADAMANTYLMONOMERE UND POLYMERE FÜR LOW-K-DIELEKTRIK ANWENDUNGEN
MONOM RES ET POLYM RES D'ADAMANTYLE POUR APPLICATIONS DI LECTRIQUES FAIBLE PERMITTIVIT

(30) Priority: 23.12.2003 US 531659 P
(43) Date of publication of application: 18.10.2006
(73) Proprietor: Silecs OY, 02150 Espoo (FI)
(72) Inventor: PAULASAARI, Jyri, FI-20810 Turku (FI); RANTALA, Juha, FI-02150 Espoo (FI)
(74) Representative: Sundman, Patrik Christoffer
(86) International application number: PCT/FI2004/000799
(87) International publication number: WO 2005/061587

(56) References cited:
- EP-A1- 1 026 213
- EP-A1- 1 462 470
- EP-A1- 1 505 053
- WO-A1-03/059990
- WO-A1-2004/078701
- WO-A2-03/015129
- DE-A1- 10 333 571
- JP-A- 7 026 193
- JP-A- 2000 302 791
- JP-A- 2004 315 461
- SU-A1- 763 347
- US-A1- 2003 186 494
- US-A1- 2004 002 617
- US-A1- 2005 064 726
- GRISTINA E. V. ET AL: 'Antiviral activity of organosilicon compounds with an adamantyl fragment' KHIMIKO-FARMATSEVTICHESKII ZHURNAL vol. 22, no. 3, 1988, pages 315 - 316, XP009064102
- PAI Y. M. ET AL: '1,3-Adamantanyl dimethylsiloxane copolymers. Preparation and properties' APPLIED ORGANOMETALLIC CHEMISTRY vol. 1, 1987, pages 171 - 176, XP009064094

## Description

The present invention concerns novel silane compounds according to claims 1 and 21.

The present invention also concerns novel polymers according to claims 9, 24 and 25.

A wide variety of inorganic and organic films having high temperature stability have been proposed for both spin-on and Chemical Vapor Deposition (CVD) low-k and Ultra Low-k (ULK) applications. The only materials capable thus far of successful integration in copper dual damascene processing have been inorganic films with k values of ≥ 3.0.

Sub 90 nm generations of Integrated Circuit (IC) manufacture require effective k values substantially lower than 3.0. A common and relatively simplistic approach is to use porogenation processes that introduce void volume in the film. These porogen-based approaches have all failed in IC process integration for various reasons and new approaches are needed to avoid the pitfalls associated with porous films.

There are particular problems with current porous ULK films. Thus, in the ULK films developed to date, as much as 40 % porosity may be introduced to achieve k values around 2.2, usually at the expense of a significant lowered mechanical properties of the materials. Porogenation processes commonly employ techniques that bum out organic molecules at elevated temperatures to generate relatively large holes in the film. It is well known that for most low k materials the dielectric constant has an almost linear relationship with porosity and that mechanical properties, e.g. modulus and hardness, are a power function of porosity. Thus, while dense CVD oxide has a modulus of 70 GPa and a k value of 4.0-4.2, most films with k values - 3.0 have < 10 % porosity and modulus values of 5-15 GPa, while most mesoporous films with k values < 2.5 have a porosity of 30 to 50 % and modulus values of only 1 - 4 GPa. The semiconductor roadmap guideline stipulates modulus of 4 GPa to pass blanket and patterned CMP (chemi-mechanical polishing) with acceptable yields.

CMP is a huge integration challenge for low-k dielectrics. High porosity volumes result in stress voiding in the dielectric after metal CMP, particularly in smaller features, and is associated with damage to the porous dielectric during via etch. Stress voiding does not occur in dense siloxanes that have only intrinsic porosity.

In addition to mechanical shortcomings, there are other problems associated with highly porous films. These films are subject to high etch rates and are prone to carbon depletion during etching of vias and trenches. Even though etching is carried out at anisotropic conditions, carbon depletion occurs at the sidewalls damaging the integrity of the dielectric. This damage results in larger pores at the sidewall, higher leakage and higher k and moisture absorption into the film, preventing timed etch processing. Carbon depletion results in film damage at the bottom of the trench during trench etch. To avoid this damage, a thick buried etch stop layer must be added resulting in not only an increase in the number of process steps from one to three, but also in a large increase in the effective k of the dielectric stack.

Furthermore, the buried etch stop process does not help in preventing damage to the sidewalls of the porous films. Carbon depletion in low-k dielectrics increases as a function of porosity and is minimized in dense films.

With so many issues facing the integration of porous films, it is difficult to envision how these can ever be integrated into standard IC processing. Even if the porosity is not introduced until after the completion of metallization processing, it is still questionable whether the porous dielectric stack can withstand the rigors of packaging.

It is an aim of the present invention to provide low-k and ULK films that have the desired mechanical properties for process integration. In the present invention, molecular engineering is used to achieve this goal. In particular, the present invention provides a new way to achieve the desired ULK values and thermal-mechanical properties without the introduction of porogenation.

The present invention is based on the idea of providing an alternative approach to the porogenation process by engineering the precursor molecules up-front to achieve the properties that are desired and needed by the industry. Designing of suitable materials includes the features of, e.g., tuning polarizabilities, balancing orientational and electronics polarizabilities and tuning intramolecular controlled free volume.

The invention provides novel materials, which are based on a silsesquioxane backbone structure and which contain modified novel moieties to provide specific desired properties for a final ULK material.

Based on the above, the invention concerns novel silane compounds, which include an adamantyl residue linked to a silicon atom either directly by a carbon-to-silicon bond or, alternatively, via a bridging group, such as an alkylene group. The novel compounds contain at least one hydrolysable group linked to the silicon atom so as to provide for the polymerization of the compounds, e.g. for producing polymers useful as low-k materials.

Adamantane derivatives are known in the art. Thus, 1,3-dehydroadamantane has been described in scientific articles. So have some other dehydroadamantane derivatives, including monomethyl dehydroadamantane and 1,3-dehydro-5,7-dimethyladamantane. The latter compound has been synthesized from the corresponding starting material using potassium, sodium, HMPA and t-BuOH to yield the desired compound after fractionation. Adamantyl silanes and their use for the manufacture of polymers have been described in JP 2000 302791. However, no chlorosilane derivatives have been disclosed in the art.

The present novel monomers have, in particular, the following formula I: 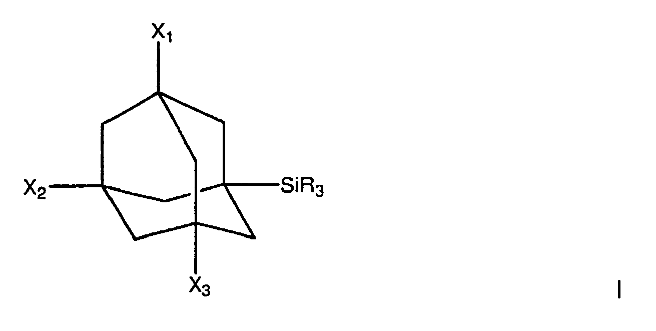 wherein
X₁, X₂ and X₃ are independently selected from the group of hydrogen and optionally substituted alkyl groups having 1 to 10 carbon atoms,
with the proviso that at least one of X₁, X₂ and X₃ is different from hydrogen, and,
each R stands independently for a hydrolysable group.

The novel silane monomers can be economically produced at high yield and purity by a novel chemical process involving as a key intermediate adamantyl dehydrate having the formula

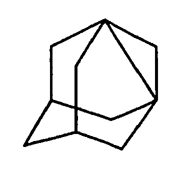

In the process, a halo-substituted adamantane compound is converted to the corresponding dehydroadamantane derivative, which then is silylated with a suitable silane compound, e.g. trichlorosilane.

The the bridging bond between adamantanyl and silicon can be also replaced by a group M resulting in a compound of formula II: 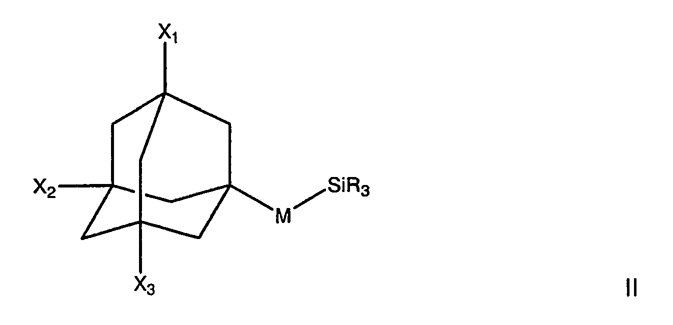 wherein,
X₁, X₂ and X₃ are independently selected from the group of hydrogen and
optionally substituted alkyl, alkenyl and alkynyl groups having 1 to 10 carbon atoms,
with the proviso that at least one of X₁, X₂ and X₃ is an alkyl, alkenyl or alkynyl group,
M is an alkylene group having 1 to 10 carbon atoms, and each R stands independently for a hydrolysable group or for an alkyl, alkenyl, alkynyl or aryl group, at least one of R standing for a halogen.

The potential of using adamantyl derivatives as monomers in polymers for low-k applications has not been fully utilized before. There are some known polymers, which have been produced from alkoxy derivatives of adamantyl silane. However, in connection with the invention, we have found that organoalkoxysilanes have a tendency of leaving residual alkoxides into the material matrix. Such residues greatly impair the use and properties of the materials in particular as regards their dielectric properties. If residual alkoxides remain in the matrix, they tend to react over time and change materials properties by forming contaminating alcohol and water into the matrix. These oxygenates impair dielectric and leakage current behavior of the material. In addition, residual alkoxies, such as ethoxide-based materials, cause a dangling bond effect that causes higher leakage current for the material. Moreover, alkoxy-based materials result in higher porosity and lower Young's modulus and hardness compared to well hydrolysable organochloro-silane and organosilanes.

Therefore, the course of the invention is to utilize more easily hydrolysable organosilanes for dielectric thin film purposes.

The present invention provides for novel polymers, which avoid the above disadvantages. The polymers comprise monomeric units derived from precursors according to formula I or II or combinations thereof,
wherein
X₁, X₂ and X₃ are independently selected from hydrogen and optionally substituted alkyl or aryl grup having 1 to 10 carbon atoms, or alkenyl or alkynyl group(s) having 1 to 10 carbon atoms, and
each R stands independently for a hydrolysable group or for alkyl, alkenyl or alkynyl or aryl group(s).

Preferably at least one of R being a hydrolysable group and the alkyl, alkenyl, alkynyl and aryl groups in the meaning of R have 1 to 10 carbon atoms.

More specifically, the monomers according to the present invention are mainly characterized by what is stated in the characterizing parts of claims 1 and 21.

The polymers are characterized by what is stated in the characterizing parts of claims 9 and 24.

The present invention provides considerable advantages. Thus, the novel materials exhibit a combination of desired properties, including a preselected degree polarizability (orientational and electronic polarizability) and intramolecular controlled free volume. High cross-linking densities improve thermo-mechanical properties and prevent pore formation caused by loss of functional groups. Highly stable bridging groups reduce CTE to achieve a match with interconnect metallization and also enhance mechanical properties and thermal stability.

The present film precursors have low pore volumes equivalent to dense films at ultra low-k values and give the desired mechanical properties. A modulus of >6.0 GPa has been demonstrated for an ULK dielectric material with thermal stability that exceeds 470 ºC and an average pore size of less than 1.5 nm under a very narrow and controlled distribution. A CTE of 15 ppm/°C makes this material compatible with both copper and aluminum metallization.

The invention will described in more closely below with reference to the following detailed description and with reference to a number of working examples.

The present invention concerns novel alkyl-substituted adamantylhalosilane and alkyl-substituted adamantylsilane monomers, which are useful in the preparation of polymers for dielectric applications.

The invention also concerns a broad variety of polymers, which are obtained by polymerization and copolymerization of adamantyl monomers.

The novel monomeric compounds of formulas I and II contain 1 to 3 alkyl, alkenyl and alkynyl groups in positions 3, 5 and 7 of the adamantyl ring in the adamantylsilane monomers. Said alkyl groups generally contain 1 to 10 carbon atoms, which may be further substituted with at least one halogen atom. As specific examples of suitable alkyl groups, the following can be mentioned: lower alkyl groups having 1 to 6 carbon atoms, such as methyl, ethyl, n-propyl, I-propyl, n-, sec- and tert-butyl, halogen-substituted methyl and ethyl groups, such as trifluoro- and trichloromethyl and pentafluoro- and pentachloroethyl groups. In addition to halo substituents, am ino, imino, hydroxy and carboxy substituents are possible. Said alkenyl and alkynyl groups contain 1 to 10 carbon atoms, typically they are vinyl, allyl or acetylene groups, and said alkenyl or alkynyl groups may optionally contain substituents, such as the ones mentioned in connection with the alkyl groups. The vinyl and allyl groups preferably have from 2 to 6 carbon atoms. The hydrolysable groups R are generally hydrogen or halogen, preferably at least one of R is halogen, in particular all are halogen, advantageously chlorine. Moreover, the hydrolysable group can also be an alkoxy, acetoxy, acyloxy and amine group. In addition, 1 to 2 of the R groups can also be non-hydrolysable groups, such as alkyl, alkenyl, alkynyl or aryl groups containing 1 to 10 carbons. These groups can optionally be substituted with 1 to 5, in particular 1 to 3, halo, hydroxyl, carboxy, amino, imino and C₁₋₆-alkyl groups. According to a preferred embodiment, at least one of R is always a hydrolysable group.

The hydrolysable groups are, according to a preferred embodiment, selected such that the monomer has a boiling point, which is suitable for processing by CVD technology. It is particular preferred to provide monomers having a lower boiling point that those of compounds according to formula I wherein R stands for an alkoxy group.

Typically, the boiling point is less than 350 ºC.

3,5-dimethyl adamantyl trichlorosilane and 3,5-dimethyl adamantyl silane can be mentioned as particularly interesting novel compounds useful, e.g., in the polymerization of low-k polymers.

Polymers can be obtained by conventional polymerization of the novel monomers (cf. below). However, new polymers, having interesting properties, can be obtained by polymerization of even a broader group of monomers corresponding to formula I. In the definition of such monomers, X₁, X₂ and X₃ are independently selected from hydrogen and optionally substituted alkyl groups having 1 to 10 carbon atoms, or alkenyl and alkynyl groups having 1 to 10 carbon atoms, and each R stands independently for a hydrolysable group. However, one to two R groups can also comprise non-hydrolysable groups selected from alkyl, alkenyl, alkynyl or alkyl groups. These groups can optionally be substituted with 1 to 5, in particular 1 to 3, halo, hydroxyl, carboxy, amino, imino and C₁₋₆-alkyl groups.

As mentioned above, the bridging bond between adamantanyl and silicon can be also replaced by a group M resulting in a compound of formula II. M is typically an alkylene group having 1 to 10 carbon atoms. Preferably, the M group is a methylene, ethylene or propylene group, which optionally may bear 1 or 2 substituents, selected from halo, C₁₋₆-alkyl groups, hydroxyl, carboxy, amino and imino groups, per methylene unit.

Further, as discussed in more detail in our copending application titled "Organo-silsesquioxane polymers for forming low-k dielectrics" (WO 2004/090019), the contents of which are herewith incorporated by reference, it is possible to tailor the properties of adamantyl-based monomers by copolymerizing them with conventional silanes. Thus, when silane precursors containing polycyclic alkyl moieties of the adamantyl kind are used for the formation of siloxane polymers, the organic content of the film is increased and, therefore, the content of carbon related oxygen is significantly reduced compared to siloxane polymers formed from precursors containing small alkyl groups. Examples of the latter kind of precursors are the methyl-substituted siloxanes. Thus, for example, if each silicon atom in the siloxane matrix contains one organic group, in case of adamantyl, the atomic ratio of carbon to oxygen is 6.67, whereas in case of methyl, the same ratio is 0.667. Thus, methyl siloxane polymer contains 10 times more permanent dipoles than an adamantyl containing siloxane polymer. This difference in the content of permanent dipoles affects orientational polarizability so that the orientational dielectric constants are 0.3 for the adamantyl and 0.7 for the methyl substituted siloxane polymers, respectively.

This interesting effect can be utilized by using adamantyl (halo)silanes as comonomers in combination with metyl and other alkyl siloxane derivatives as well as with vinyl siloxanes and aryl siloxanes (such as phenyl siloxane) and with mixtures thereof, e.g. with methyl, vinyl, phenyl.siloxanes. Dielectric materials having interesting properties can be obtained for example by using about 10 to 50 mole-% of polycyclic alkyl siloxanes, about 30 to 80 mole-% alkyl siloxanes (in particular methyl siloxanes) and the rest, typically about 5 to 30 mole-% vinyl siloxanes/aryl siloxanes.

Precursors consisting of monomers of formulas I or II or combinations thereof and compositions comprising said monomers can be polymerized by using polymerization techniques known in the art, yet resulting in novel dielectric polymer compositions that are particularly applicable to integrated circuit applications. These polymerization methods can be, for example, hydrolysis and condensation polymerization of hydrolysable moieties, carbon double or triple bond chain and cross-linking polymerization and hydrosilylation polymerization. Furthermore, when these kinds of polymerization methods are used also various types of polymerization catalysts can be employed, such as thermal and photo activated free radical, anionic and cationic catalysts, acids and bases as well as metal complexes. Also combinations of above-mentioned polymerization methods can be applied.

The present invention also concerns a method of forming a thin film having a dielectric constant of 2.5 or less, comprising
- hydrolyzing a first silicon compound having the formula I optionally with a second silicon compound to produce a siloxane material;
- depositing the siloxane material in the form of a thin layer on a substrate; and
- curing the thin layer to form a film.

The second silicon compound can be a compound selected from, e.g., the following groups:
Compounds having the formula

   (R³-R⁴)ₙ-Si-(X²)₄₋ₙ, III

   wherein
   X² is hydrogen or a hydrolysable group selected from halogen, acyloxy, alkoxy and OH groups,
   R⁴ is an optional group and comprises an alkylene having 1 to 6 carbon atoms or an arylene and
   R³ is an alkyl having 1 to 16 carbon atoms, a vinyl having from 2 to 16 carbon atoms, a cycloalkyl having from 3 to 16 carbon atoms, an aryl having from 5 to 18 carbon atoms or a polycyclic alkyl group having from 7 to 16 carbon atoms,
   and n is an integer 1-3;
Compounds having the general formula IV

   X³₃₋ₐ-SiR⁵_{b}R⁶_{c}R⁷_{d} IV
wherein X³ represents a hydrolyzable group; R⁴ is an alkenyl or alkynyl group, which optionally bears one or more substituents; R⁵ and R⁶ are independently selected from hydrogen, substituted or non-substituted alkyl groups, substituted or non-substituted alkenyl and alkynyl groups, and substituted or non-substituted aryl groups; a is an integer 0, 1 or 2; b is an integer a+1; c is an integer 0, 1 or 2; d is an integer 0 or 1; and b + c + d = 3; is hydrolyzed;
Compounds having the general formula V

   X⁴₃₋ₑ-SiR⁸_{f}R⁹_{g}R¹⁰ₕ V
wherein X⁴ represents a hydrolyzable group; R⁸ is an aryl group, which optionally bears one or more substituents; R⁹and R¹⁰ are independently selected from hydrogen, substituted or non-substituted alkyl groups, substituted or non-substituted alkenyl and alkynyl groups, and substituted or non-substituted aryl groups; e is an integer 0, 1 or 2; f is an integer e+1; g is an integer 0, 1 or 2; h is an integer 0 or 1; and f + g + h = 3;
Compounds having the general formula VI

   X⁵₃₋ᵢ-SiR¹¹ⱼR¹²ₖR¹³ₗ VI
wherein X⁵ represents a hydrolyzable group; R¹¹ is a hydrogen or an alkyl group, which optionally bears one or more substituents; R¹² and R¹³ are independently selected from hydrogen, substituted or non-substituted alkyl groups, substituted or non-substituted alkenyl or alkynyl groups, and substituted or non-substituted aryl groups; i is an integer 0, 1 or 2; j is an integer i+1; k is an integer 0, 1 or 2; I is an integer 0 or 1; and j + k + I = 3; and
Compounds having the formula VII,

   (R³-R⁴)ₙ-Si-(X²)₄₋ₙ, VII

   wherein
   X² is hydrogen or a hydrolysable group selected from halogen, acyloxy, alkoxy and OH groups,
   R⁴ is an optional group and comprises an alkylene having 1 to 6 carbon atoms or an arylene and
   R³ is an alkyl having 1 to 16 carbon atoms, a vinyl having from 2 to 16 carbon atoms, a cycloalkyl having from 3 to 16 carbon atoms or an aryl having from 5 to 18 carbon atoms,
   and n is an integer 1-3.

The alkyl groups of R³ have typically 1 to 6 carbon atoms, the vinyl groups have from 2 to 6 carbon atoms, and the aryl groups have 6 carbon atoms.

The molar ratio between monomeric units derived from compounds according to formulas I and/or II and one or several monomeric unit derived from compounds of a formula III to VII is preferably in the range of 5:95 to 95:5, preferably about 10:90 to 90:10, in particular 25:75 to 75:25.

Compounds a) to c) are disclosed in more detail in International Patent Application No. WO 03059990, the disclosure of which is herewith incorporated by reference.

The present invention further relates to a method of lowering the dielectric constant of the optimized materials in terms of the by rapid thermal curing (RTC). In such a process, the dielectric material is cured (densified and/or cross-linked) by increasing the temperature of the material at a rate, which is at least 6 times faster than in conventional curing. As a result, the heating ramp (the time it takes to reach curing temperature) is steep. The actual curing time can also be shorter than conventionally. Typically, the curing time is one sixth of the conventional time in the same heating tool. The temperature difference between the starting temperature and actual the curing temperature is at least 150 °C. At larger temperature differences, lower dielectric constants are achieved due to changed microstructure of the film material. It is not the course of the invention to claim the changed microstructure, but the changes in the structures due to the RTC treatment are likely due to phase change between ordered and disordered microstructures in silicon dioxide part of the matrix that results less densely packed structure than can be obtained as slightly increased micro-porosity.

According to a preferred embodiment of the above methods, a non-porous dielectric material is first provided by conventional processing, e.g. by a spin-on or CVD process.

The temperature (also called "the first temperature") of the typically paste-like material is in the range of 100 to 200 ºC. The material is free from intentionally incorporated porogens in order to provide a nonporous dielectric material. The elastic modulus of the paste-like material is low. After the deposition of the material on a suitable support, in particular on a semiconductor substrate, the material can optionally be pretreated, as will be explained below in more detail, and then cured by a thermal curing process, in which the material is rapidly heated to an increased (second) temperature.

In the RTC method alternative, the temperature can be increased at an average rate of at least 1 °C, preferably at least 10 °C, in particular at least 30 °C, per second. Thus, a densified nonporous dielectric material having an elastic modulus, which is greater than the elastic modulus of the starting material, can be obtained.

Accordingly, the polymerization and densification reactions of the material are activated in a rapid curing furnace so that relative dielectric constant of the dielectric film is lower than a predetermined value. Such a predetermined value corresponds to that of a conventional furnace, which means a furnace in which the material is heated at a rate of about 10 deg C or less per minute and in which it is cured for extensive periods of at least 15 minutes, typically more than 30 minutes. By the RTC process, the dielectric constant of the same material will be decreased by more than 0.1 as a result of the rapid thermal curing.

As mentioned above, the temperature difference between the second and the first temperature should be large, preferably it is at least 200 °C, and in particular in the range of from 225 to 425 °C, and most preferably at least 275 °C.

However, it should be pointed out that the present materials can also be processed by conventional thermal processing.

The dielectric constant of the densified material is 2.60 or less, preferably 2.50 or less, in particular 2.40 or less. The CTE of the film is less than 25 * 10⁻⁶ 1/degC.

The material can be characterized as being "nonporous" which, in the present context means, in particular, that the porosity is low, typically less than 25 %, preferably less than 20 %, in particular less than 15 % (by volume), and the average pore size is less than 5 nm, preferably less than 2 nm and in particular less than 1 nm. As a result of the processing, the electronic polarizability of the film is decreased more than 0.1 compared to a predetermined value obtained by conventional processing, as explained above.

As mentioned above, the nonporous dielectric material can be subjected to annealing or a similar pretreatment or post-treatment of heated to the second temperature, i.e. the actual curing temperature. Annealing is carried out, e.g., by a process in which the material is subjected to UV radiation, DUV radiation, Extreme UV radiation, IR radiation or e-beam radiation or a combination thereof. The annealed material is then subjected to curing at an elevated temperature in air, nitrogen, argon, forming gas or vacuum.

The pre-cure and rapid cure processes according to the present invention, result in a dielectric film free of silanols.

The annealed and cured (densified, crosslinked) material can be subjected to deposition of a second layer selected from a metal, a barrier, a liner or an additional dielectric layer.

Based on the above, the present invention provides a process for preparing a siloxane-based dielectric material on a semiconductor substrate by hydrolysis and condensation of corresponding reactants, applying the prepared compositions on a substrate in the form of a thin layer, patterning the film by selective radiation and developing the radiated film and curing the formed structure.

As an embodiment of the above process, the material above is processed first by introducing a monomeric or polymerized material on a semiconductor substrate by a spin-on or CVD method, and then forming a siloxane polymer film on the semiconductor substrate by activating polymerization and densification reactions by rapid curing processing so as to produce a material having a relative dielectric constant lower than 2.6, preferably less than 2.5, in particular less than 2.4. Typically the dielectric constant is between 2.0 and <2.6.

The pore size of the nonporous dielectric material is less than 2 nm, the co-efficient of thermal expansion less than 25 ppm/degC, and the thermal decomposition temperature higher than 450 °C.

The electrically insulating material can be baked and patterned, with an electrically conductive material being deposited in removed areas of the patterned dielectric. The electrically conductive material comprises, for example, copper.

The above process is, e.g., a dual damascene process.

The deposition and patterning processes are described, for instance, in our earlier application PCT/FI03/00036, the disclosure of which is herewith incorporated by reference.

The following non-limiting examples illustrate the invention:

### Example 1

### Synthesis of 1,3-dimethyladamantyltrichlorosilane

### Step A. 1,3-Dimethyl-5,7-dibromoadamantane (I)

1,3-Dimethyl-5-bromoadamantane (46 g) and bromine (15 mL) were placed in a rb flask. Iron(III)bromide (10 mg, previously prepared at rt in 24 hours from iron powder and bromine, catalyzed by small amount of adamantine). The reaction was all owed to proceed at rt until no HBr gas evolved. The crude product was dissolved in dichloromethane and washed with dilute HCl and dilute sodium thiosulfate. The organ ic layer was separated, it was evaporated and the residue was recrystallized once from octane. In this way, 42 grams of 1,3-dimethyl-5,7-dibromoadamantane was obtained. Purity according to GC was 98.3 %. The synthesis was repeated twice.

### Step B. 1,3-Dimethyl dehydroadamantane (II)

Lithium metal (14.8 g) and dry ether (100 mL) were placed in a three neck flask, equipped with a condenser and a magnetic stir bar under argon. Compound I (69.2 g) in 250 mL ether was slowly added. Ice bath under the flask was used to keep the reaction in control. One hour after addition of all the bromide, GC showed 100 % conversion. Ether was evaporated and 1,3-dimethyl dehydroadamantane was dissolved in pentane. The liquid part was transferred into another flask via a canula, and pentane was evaporated giving white solid. GC analysis showed 99 % purity of 1,3-dimethyl dehydroadamantane. The compound could be further purified by sublimation.

### Step C. 1,3-Dimethyladamantyltrichlorosilane (III)

Trichlorosilane (126 g) was added into the flask containing II. A solution of 5 %-w/v chloroplatinic acid in isopropanol (80 µL) was injected. After a short induction period, the flask started to reflux gently. After 24h, the excess trichlorosilane was evaporated and the remaining solid, which melted at around 60, was distilled, giving 1,3-Dimethyladamantyltrichlorosilane, 56.8 g (88%, bp. 82-100°C / 1 mbar). The purity of 1,3-Dimethyladamantyltrichlorosilane was measured to be 95.7% by GC. By using dicobalt octacarbonyl as a catalyst instead of chloroplatinic acid, a purity of over 99 % could be achieved.
1H NMR:0.3-2.3 ppm (m). 13C NMR: 29.3, 30.6, 31.5, 32.7, 34.2, 41.6, 43.5, 51.3 ppm. 29Si NMR:13.8 ppm. GC/MS (m/z): 296 (1, [M]+), 283 (4), 281 (4, [M-15] +), 163 (100), 135 (8), 107 (42), 91 (13).

### Example 2

### Adamantyl silanol, hydrolysis product of III (IV).

III (7.0 g) was dissolved in dry acetone (50 mL). The solution was dripped in well-stirred solution of 4.7 g distilled water, triethylamine (9.3 g) and acetone (70 mL) at 0 °C. After the addition, the reaction was allowed to proceed for 1½ hours at rt. The content of the flask was poured into 500 mL water, and the solids were separated by filtration. And washed with dist. water. After drying in vacuum for 24 hours, adamantyl silanol (IV, 4.7 g) as white powder was obtained. Sample contained many Si-OH - groups, as indicated by the strong absorption in IR-spectrum between 3000-3750 cm-1. Alternatively, the hydrolysis product could also be made by refluxing III in toluene/water mixture overnight. IV precipitated out from solution as white powder.

### Example 3

### Alternative monomers:

### A. Adamantylsilane (VII):

Lithium aluminum hydride (6.18 g) and dry ether (80 mL) were placed in a rb flask. Adamantyl trichlorosilane (50.8 g), dissolved in ether (50 mL) was added dropwise in the magnetically stirred flask at rt. The reaction was allowed to reflux for 24h. The solution was filtered, evaporated, and 1 mL Et3N in 30 mL pentane was then added and the upper layer was carefully decanted. After evaporation, the crude reaction product was distilled, giving 22 g of VII (70%, bp. 40...50 °C / 2 mbar).
1H NMR: 1.95 (15H), 3.68 (3H). 13C NMR: 20.63, 28.86, 37.99, 40.61. 29Si NMR: - 43.55 (q, Si-H: 190 Hz). Purity was found to be 95.7% by GC.

### B. Adamantylchlorosilylbis(dimethylamine) (VIII):

Adamantyltrichlorosilane (5.59 g), Et3N (9.5 g) and dry ether (40 mL) were placed in a rb flask. Dimethylamine (3.05 g) was slowly bubbled into the solution at 0 °C in 45 minutes. The reaction was allowed to stir for 18 hours at rt. It was then filtered, and volatiles were removed by vacuum. Distillation at 88...98 °C / 1 mbar gave a fraction 4.54 g (76%). Purity was 97% by GC.
GC/MS (m/z): 296 (62, [M]+), 243 (42), 151 (100), 135 (43), 108 (33), 79 (17), 74 (37). 1H NMR: 1.99 (3H), 2.08 (6H), 2.19 (6H), 2.74 (12H). 13C NMR: 28.63, 38.29, 39.07, 48.68.14N NMR: -373.9, 29Si NMR: -10.16.

### C. 1-Methyl-3,5-dibromoadamantane:

1-Methyladamantane (15 g) and ferric bromide (20 mg) dissolved in dichloromethane (5 mL), were placed in a 100 mL three-neck rb flask. Bromine (11.5 mL) was then slowly added via a syringe while HBr-gas was bubbled into ice water. Reaction temperature was kept at 40 °C for 15 hours. The reaction was washed with dil. HCl and dil. sodium thiosulphate solutions, after which dichloromethane was evaporated in vacuum. Recrystallization from n-octane gave the product in 86% yield (26.3 g).

### D. 1,3,5-Trimethyl-7-(trichlorosilylpropyl)-adamantane:

29.40 g (0.179 mol) dimethyladamantane, 9.5 ml (29.55 g, 0.185 mol) bromine and 0.5 g FeBr3 were added to a 250 ml vessel at room temperature. The solution was stirred for over night.

100 ml DCM and 100 ml dilute HCl were added to the vessel. An aqueous solution of sodium thiosulfate was added until the color of bromine disappeared. The organic layer was collected and it was washed two more times with 100 ml dilute HCl. DCM was evaporated and the remaining liquid was distilled to give 26.70 g (yield 61.5 %) Me2AdBr. B.p. 109 °C / 0.75 mbar.

26.70 g (0.110 mol) Me₂AdBr was added to a 500 ml vessel followed by 100 ml i-Pr₂O. The solution was heated up to 82 °C and 76 ml 3M MeMgBr (0.228 mol) was slowly added. Formation of white precipitation (Mg-salts) started immediately. The solution was stirred at 82 °C over night.

The solution was cooled down to room temperature and 1 M HCl was added slowly (max 1ml at a time) to decompose excess MeMgBr. After formation of methane wasn't observed any more 1 M HCl was added that much that all Mg-salts dissolved. Organic layer was once more washed with 200 ml 1M HCl. After that the organ i c layer was collected and the solvent was evaporated. The remaining crude Me3Ad was distilled. B.p. 56 °C / 0.8 mbar. Yield 12.70 g (64.5 %).

12.70 g (0.071mol) Me3Ad was added to a 100 ml vessel followed by 50 ml DCM and 2.2 g (0.016 mol) AlCl3. The solution was heated up to 40 °C and 22.50 g (0.128 mol) allyl trichlorosilane was added during 15 min. After stirring an hour at 40 °C all Me₃Ad had reacted and the solution was cooled down to room temperature. Volatiles were evaporated and remaining liquid was distilled twice. B.p. 106 °C / 0.35 mbar. Yield 10 g (40 %).

### Example 3

### Adamantyl silanol, prepolymer (V)

A clear solution of adamantyl silanol (IV) in 10 mL dimethylacetamide was dripped in a second solution containing methyltrichlorosilane (15.8 g), vinyltrichlorosilane (2.0 g), triethylamine (8.8 g) and dry ether (77 mL) at 0 °C. The reaction was allowed to continue at room temperature for two hours, after which vacuum was applied and the solvents were evaporated at 50 °C. The solids were dispersed in dichloromethane (80 mL), and concentrated HCl (24 mL) was slowly added while stirring at 0 °C. Stirring was continued two hours and another one hour at room temperature. The water layer was decanted, and the organic layer was washed five times with distilled water until pH was 6. Dichloromethane was evaporated under vacuum. In this way, an adamantyl silanol prepolymer (4.5 g) as white powder, was obtained. Mp = 4 760 mol/g.

### Example 4

### Polymer (VI)

Adamantyl silanol prepolymer (V) was dissolved in a solution of 130 mL toluene and 130 µL triethylamine. It was allowed to reflux for two hours under argon, after which the solvents were removed by evaporation at 50 °C, giving 4.5 grams white solids, Mp = 16 270 g/mol. 1H NMR: 0.00 (100), 0.57 (132), 0.93, 1.15 and 1.38 (total 266), 1.77 (26), and 5.79 (18). This corresponds approximately to a molar ratio of AdSi:CH3Si:ViSi = 36:54:10. TGA in N₂ showed a 6.2 % weight-loss at 440 °C, 8.2 % at 490 °C and 25.5 % at 550 °C. A two-gram portion was dissolved in 8 g mesitylene and 40 mg BYK®-306 (surface additive by BYK-Chemie GmbH, Germany).

## Claims

1. A silane compound having the formula I 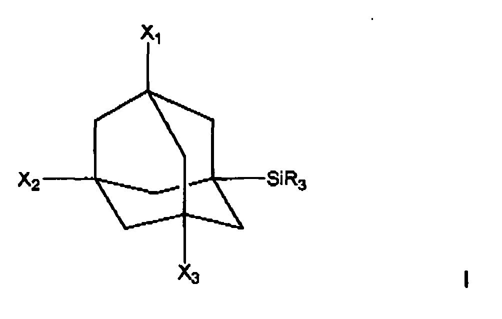 wherein
X₁, X₂ and X₃ are independently selected from the group of hydrogen, optionally substituted alkyl, alkenyl and alkynyl groups having 1 to 10 carbon atoms,
with the proviso that at least one of X₁, X₂ and X₃ is different from hydrogen, and,
each R stands independently for a hydrolysable group or an alkyl, alkenyl, alkynyl, aryl group, at least one of R being a hydrolysable group.

2. The compound according to claim 1, having a boiling point of less than 350 °C.

3. The compound according to claim 1 or 2, wherein at least one of X₁, X₂ and X₃ is a lower alkyl comprising 1 to 6 carbon atoms, which optionally is substituted with 1 to 5 halogen atoms.

4. The compound according to claim 3, wherein at least one of X₁, X₂ and X₃ is selected from methyl, ethyl, trihalomethyl and pentahaloethyl.

5. The compound according to any of the preceding claims, wherein at least one hydrolysable R group is selected from the group of hydrogen and halogen.

6. The compound according to claim 5, wherein the hydrolysable R group is chlorine, bromine or fluorine.

7. 3,5-dimethyl adamantyl trichlorosilane.

8. 3,5-dimethyl adamantyl silane.

9. A polymer with a low dielectric constant, capable of providing a thin film having a dielectric constant of 2.5 or less, comprising monomeric units derived from precursors according to formula I 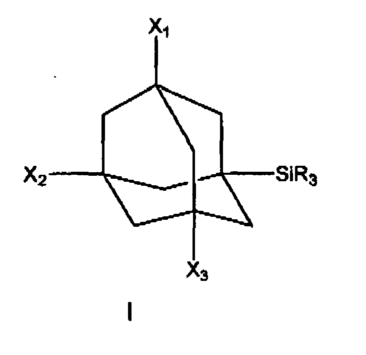 wherein
X₁, X₂ and X₃ are independently selected from hydrogen and optionally substituted alkyl, alkenyl and alkynyl groups having 1 to 10 carbon atoms, with the proviso that at least one of X₁, X₂ and X₃ is different from hydrogen, and
each R stands independently for a hydrolysable group or for an alkyl, alkenyl, alkynyl or aryl group, at least one of R being a hydrolysable group.

10. The polymer according to claim 9, wherein boiling point of the monomeric unit according to formula I is below 350 °C.

11. The polymer according to claim 9 or 10, wherein at least one of X₁, X₂ and X₃ is a lower alkyl comprising 1 to 6 carbon atoms, which optionally is substituted with 1 to 5 halogen atoms.

12. The polymer according to claim 11, wherein at least one of X₁, X₂ and X₃ is selected from methyl, ethyl, trihalomethyl and pentahaloethyl.

13. The polymer according to any of the preceding claims, wherein at least one hydrolysable R group is selected from the group of hydrogen, halogen, acyloxy, alkoxy and OH groups.

14. The polymer according to claim 13, wherein the hydrolysable R group is hydrogen.

15. The polymer according to claim 13, wherein the hydrolysable R group is chlorine, bromine or fluorine.

16. The polymer according to claim 9, wherein the monomeric units are derived from at least one of 3,5-dimethyl adamantyl trichlorosilane and 3,5-dimethyl adamantyl silane.

17. The compound according to claim 1, wherein one of the R groups is an alkyl, alkenyl, alkynyl or aryl group, preferably having 1 to 10 carbon atoms.

18. The compound according to claim 1, wherein the two of the R groups are independently selected from alkyl, alkenyl, alkynyl and aryl groups, preferably having 1 to 10 carbon atoms.

19. The compound according to claim 17 or 18, wherein the R group is a vinyl group.

20. The compound according to claim 17 or 18, wherein the R group is an acetylene group.

21. A silane compound having the formula II 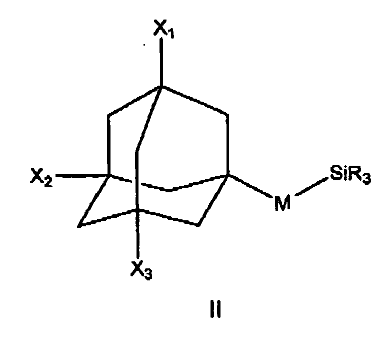 wherein
X₁, X₂ and X₃ are independently selected from the group of hydrogen and optionally substituted alkyl, alkenyl and alkynyl groups having 1 to 10 carbon atoms,
with the proviso that at least one of X₁, X₂ and X₃ is an alkyl, alkenyl or alkynyl group,
M is alkylene group having 1 to 10 carbon atoms,
each R stands independently for a hydrolysable group or for an alkyl, alkenyl, alkynyl or aryl group, at least one of R standing for a halogen.

22. The silane compound according to claim 21, wherein at least one of R stands for a hydrolysable group.

23. The compound according to claim 21, comprising 1,3,5-trimethyl-7-(trichlorosilylpropyl)-adamantane.

24. A polymer with a low dielectric constant, capable of providing a thin film having a dielectric constant of 2.5 or less, comprising monomeric units derived from precursors according to formula II 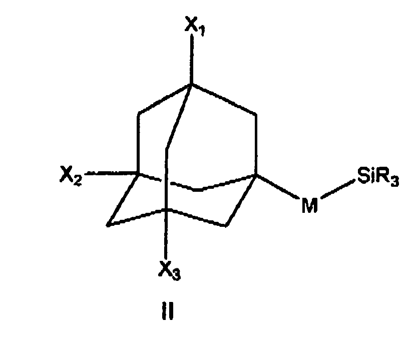 wherein,
X₁, X₂ and X₃ are independently selected from the group of hydrogen and optionally substituted alkyl, alkenyl and alkynyl groups having 1 to 10 carbon atoms,
with the proviso that at least one of X₁, X₂ and X₃ is an alkyl, alkenyl or alkynyl group,
M is alkylene group having 1 to 10 carbon atoms,
each R stands independently for a hydrolysable group or an alkyl, alkenyl, alkynyl or aryl group, at least one of R being a hydrolysable group.

25. A polymer with a low dielectric constant, capable of providing a thin film having a dielectric constant of 2.5 or less, comprising monomeric units derived from precursors according to formulas I and II, wherein
for formula I:
X₁, X₂ and X₃ are independently selected from the group of hydrogen, optionally substituted alkyl, alkenyl and alkynyl groups having 1 to 10 carbon atoms,
with the proviso that at least one of X₁, X₂ and X₃ is different from hydrogen, and,
each R stands independently for a hydrolysable group or an alkyl, alkenyl, alkynyl, aryl group, at least one of R being a hydrolysable group
and
for formula II:
X₁, X₂ and X₃ are independently selected from the group of hydrogen and optionally substituted alkyl, alkenyl and alkynyl groups having 1 to 10 carbon atoms,
with the proviso that at least one of X₁, X₂ and X₃ is an alkyl, alkenyl or alkynyl group,
M is alkylene group having 1 to 10 carbon atoms,
each R stands independently for a hydrolysable group or for an alkyl, alkenyl, alkynyl or aryl group, at least one of R standing for a halogen.

## Patentansprüche

1. Silanverbindung der Formel I 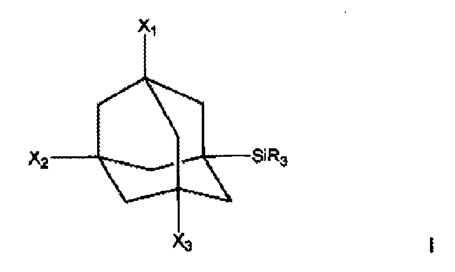 wobei
X₁, X₂ und X₃ unabhängig ausgewählt sind aus der Gruppe von Wasserstoff, wahlweise substituierten Alkyl-, Alkenyl- und Alkinylgruppen mit 1 bis 10 Kohlenstoffatomen,
mit der Maßgabe, dass mindestens eines von X₁, X₂ und X₃ von Wasserstoff verschieden ist,
und
jedes R unabhängig für eine hydrolysierbare Gruppe oder eine Alkyl-, Alkenyl-, Alkinyl-, Arylgruppe steht, wobei mindestens eines von R eine hydrolysierbare Gruppe ist.

2. Verbindung nach Anspruch 1 mit einem Siedepunkt von weniger als 350°C.

3. Verbindung nach Anspruch 1 oder 2, wobei mindestens eines von X₁, X₂ und X₃ ein 1 bis 6 Kohlenstoffatome umfassendes Niederalkyl ist, das wahlweise mit 1 bis 5 Halogenatomen substituiert ist.

4. Verbindung nach Anspruch 3, wobei mindestens eines von X₁, X₂ und X₃ ausgewählt ist aus Methyl, Ethyl, Trihalogenmethyl und Pentahalogenethyl.

5. Verbindung nach einem der vorangehenden Ansprüche, wobei mindestens eine hydrolysierbare R-Gruppe ausgewählt ist aus der Gruppe von Wasserstoff und Halogen.

6. Verbindung nach Anspruch 5, wobei die hydrolysierbare R-Gruppe Chlor, Brom oder Fluor ist.

7. 3,5-Dimethyladamantyltrichlorsilan.

8. 3,5-Dimethyladamantylsilan.

9. Polymer mit einer niedrigen dielektrischen Konstante, das in der Lage ist, einen dünnen Film mit einer dielektrischen Konstante von 2,5 oder weniger bereitzustellen, umfassend Monomereinheiten, die abgeleitet sind von Vorläufern gemäß Formel I 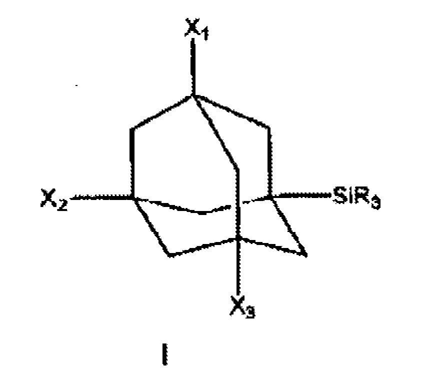 wobei
X₁, X₂ und X₃ unabhängig ausgewählt sind aus der Gruppe von Wasserstoff und wahlweise substituierten Alkyl-, Alkenyl- und Alkinylgruppen mit 1 bis 10 Kohlenstoffatomen,
mit der Maßgabe, dass mindestens eines von X₁, X₂ und X₃ von Wasserstoff verschieden ist,
und
jedes R unabhängig für eine hydrolysierbare Gruppe oder für eine Alkyl-, Alkenyl-, Alkinyl- oder Arylgruppe steht, wobei mindestens eines von R eine hydrolysierbare Gruppe ist.

10. Polymer nach Anspruch 9, wobei der Siedepunkt der Monomereinheiten gemäß Formel I unter 350°C liegt.

11. Polymer nach Anspruch 9 oder 10, wobei mindestens eines von X₁, X₂ und X₃ ein 1 bis 6 Kohlenstoffatome umfassendes Niederalkyl ist, das wahlweise mit 1 bis 5 Halogenatomen substituiert ist.

12. Polymer nach Anspruch 11, wobei mindestens eines von X₁, X₂ und X₃ ausgewählt ist aus Methyl, Ethyl, Trihalogenmethyl und Pentahalogenethyl.

13. Polymer nach einem der vorangehenden Ansprüche, wobei mindestens eine hydrolysierbare R-Gruppe ausgewählt ist aus der Gruppe von Wasserstoff, Halogen, Acyloxy-, Alkoxy- und OH-Gruppen.

14. Polymer nach Anspruch 13, wobei die hydrolysierbare R-Gruppe Wasserstoff ist.

15. Polymer nach Anspruch 13, wobei die hydrolysierbare R-Gruppe Chlor, Brom oder Fluor ist.

16. Polymer nach Anspruch 9, wobei die Monomereinheiten von mindestens einem von 3,5-Dimethyladamantyltrichlorsilan und 3,5-Dimethyladamantylsilan abgeleitet sind.

17. Verbindung nach Anspruch 1, wobei eine der R-Gruppen eine Alkyl-, Alkenyl-, Alkinyl oder Arylgruppe mit vorzugsweise 1 bis 10 Kohlenstoffatomen ist.

18. Verbindung nach Anspruch 1, wobei die zwei der R-Gruppen unabhängig ausgewählt sind aus Alkyl-, Alkenyl-, Alkinyl- und Arylgruppen mit vorzugsweise 1 bis 10 Kohlenstoffatomen.

19. Verbindung nach Anspruch 17 oder 18, wobei die R-Gruppe eine Vinylgruppe ist.

20. Verbindung nach Anspruch 17 oder 18, wobei die R-Gruppe eine Acetylengruppe ist.

21. Sinlanverbindung der Formel II 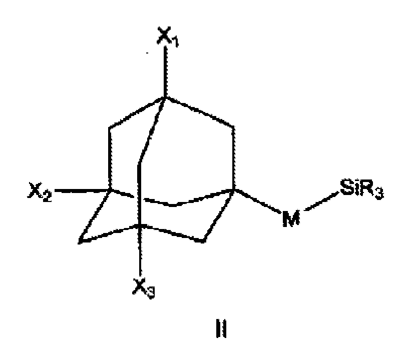 wobei
X₁, X₂ und X₃ unabhängig ausgewählt sind aus der Gruppe von Wasserstoff und wahlweise substituierten Alkyl-, Alkenyl- und Alkinylgruppen mit 1 bis 10 Kohlenstoffatomen,
mit der Maßgabe, dass mindestens eines von X₁, X₂ und X₃ eine Alkyl-, Alkenyl- oder Alkinylgruppe ist,
M eine Alkylengruppe mit 1 bis 10 Kohlenstoffatomen ist,
jedes R unabhängig für eine hydrolysierbare Gruppe oder für eine Alkyl-, Alkenyl-, Alkinyl- oder Arylgruppe steht, wobei mindestens eines von R für ein Halogen steht.

22. Silanverbindung nach Anspruch 21, wobei mindestens eines von R für eine hydrolysierbare Gruppe steht.

23. Verbindung nach Anspruch 21, umfassend 1,3,5-Trimethyl-7-(trichlorsilylpropyl)-adamantan.

24. Polymer mit einer niedrigen dielektrischen Konstante, das in der Lage ist, einen dünnen Film mit einer dielektrischen Konstante von 2,5 oder weniger bereitzustellen, umfassend Monomereinheiten, die abgeleitet sind von Vorläufern gemäß Formel II 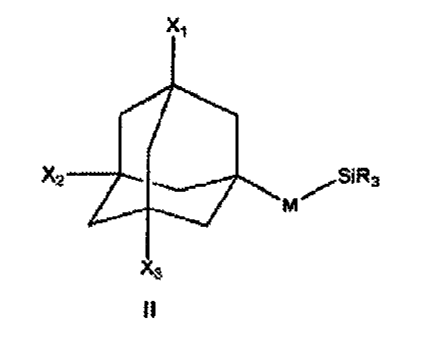 wobei
X₁, X₂ und X₃ unabhängig ausgewählt sind aus der Gruppe von Wasserstoff und wahlweise substituierten Alkyl-, Alkenyl- und Alkinylgruppen mit 1 bis 10 Kohlenstoffatomen,
mit der Maßgabe, dass mindestens eines von X₁, X₂ und X₃ eine Alkyl-, Alkenyl- oder Alkinylgruppe ist,
M eine Alkylengruppe mit 1 bis 10 Kohlenstoffatomen ist,
jedes R unabhängig für eine hydrolysierbare Gruppe oder eine Alkyl-, Alkenyl-, Alkinyl- oder Arylgruppe steht, wobei mindestens eines von R eine hydrolysierbare Gruppe ist.

25. Polymer mit einer niedrigen dielektrischen Konstante, das in der Lage ist, einen dünnen Film mit einer dielektrischen Konstante von 2,5 oder weniger bereitzustellen, umfassend Monomereinheiten, die abgeleitet sind von Vorläufern gemäß den Formeln I und II, wobei für Formel I
X₁, X₂ und X₃ unabhängig ausgewählt sind aus der Gruppe von Wasserstoff, wahlweise substituierten Alkyl-, Alkenyl- und Alkinylgruppen mit 1 bis 10 Kohlenstoffatomen,
mit der Maßgabe, dass mindestens eines von X₁, X₂ und X₃ von Wasserstoff verschieden ist,
und
jedes R unabhängig für eine hydrolysierbare Gruppe oder eine Alkyl-, Alkenyl-, Alkinyl-, Arylgruppe steht, wobei mindestens eines von R eine hydrolysierbare Gruppe ist,
und
für Formel II
X₁, X₂ und X₃ unabhängig ausgewählt sind aus der Gruppe von Wasserstoff und wahlweise substituierten Alkyl-, Alkenyl- und Alkinylgruppen mit 1 bis 10 Kohlenstoffatomen,
mit der Maßgabe, dass mindestens eines von X₁, X₂ und X₃ eine Alkyl-, Alkenyl- oder Alkinylgruppe ist,
M eine Alkylengruppe mit 1 bis 10 Kohlenstoffatomen ist,
jedes R unabhängig für eine hydrolysierbare Gruppe oder für eine Alkyl-, Alkenyl-, Alkinyl- oder Arylgruppe steht, wobei mindestens eines von R für ein Halogen steht.

## Revendications

1. Composé de silane de formule I 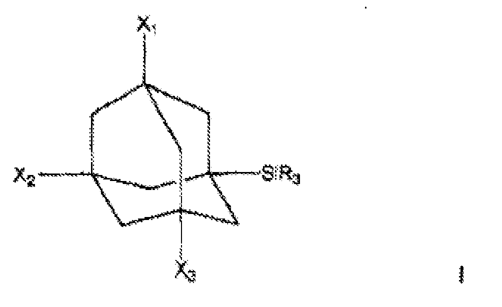 dans laquelle
X₁, X₂ et X₃ sont indépendamment choisis parmi un atome d'hydrogène, les groupes alkyle, alcényle et alcynyle ayant de 1 à 10 atomes de carbone éventuellement substitués,
à condition qu'au moins un des X₁, X₂ et X₃ soit autre qu'un atome d'hydrogène,
et,
chaque R représente indépendamment un groupe hydrolysable ou un groupe alkyle, alcényle, alcynyle ou aryle, au moins un des R étant un groupe hydrolysable.

2. Composé selon la revendication 1 ayant un point d'ébullition inférieur à 350 °C.

3. Composé selon les revendications 1 ou 2, dans lequel au moins un des X₁, X₂ et X₃ est un alkyle inférieur comprenant de 1 à 6 atomes de carbone, qui est éventuellement substitué par de 1 à 5 atomes d'halogène.

4. Composé selon la revendication 3, dans lequel au moins un des X₁, X₂ et X₃ est choisi parmi méthyle, éthyle, trihalogénométhyle et pentahalogénoéthyle.

5. Composé selon l'une quelconque des revendications précédentes, dans lequel au moins un groupe R hydrolysable est choisi parmi un atome d'hydrogène et un atome d'halogène.

6. Composé selon la revendication 5, dans lequel le groupe R hydrolysable est un atome de chlore, de brome ou de fluor.

7. 3,5-diméthyl-adamantyl-trichlorosilane.

8. 3,5-diméthyl-adamantyl-silane.

9. Polymère à basse constante diélectrique, capable de former un film mince ayant une constante diélectrique de 2,5 ou moins, comprenant des motifs monomères dérivés de précurseurs selon la formule I 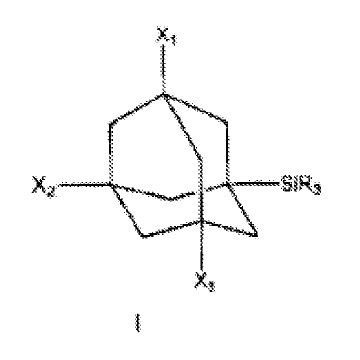 dans laquelle
X₁, X₂ et X₃ sont indépendamment choisis parmi un atome d'hydrogène et les groupes alkyle, alcényle et alcynyle ayant de 1 à 10 atomes de carbone éventuellement substitués,
à condition qu'au moins un des X₁, X₂ et X₃ soit autre qu'un atome d'hydrogène,
et,
chaque R représente indépendamment un groupe hydrolysable ou un groupe alkyle, alcényle, alcynyle ou aryle, au moins un des R étant un groupe hydrolysable.

10. Polymère selon la revendication 9, dans lequel le point d'ébullition du motif monomère selon la formule I est inférieur à 350 °C.

11. Polymère selon les revendications 9 ou 10, dans lequel au moins un des X₁, X₂ et X₃ est un alkyle inférieur comprenant de 1 à 6 atomes de carbone, qui est éventuellement substitué par de 1 à 5 atomes d'halogène.

12. Polymère selon la revendication 11, dans lequel au moins un des X₁, X₂ et X₃ est choisi parmi méthyle, éthyle, trihalogénométhyle et pentahalogénoéthyle.

13. Polymère selon l'une quelconque des revendications précédentes, dans lequel au moins un groupe R hydrolysable est choisi parmi un atome d'hydrogène, un atome d'halogène, des groupes acyloxy, alcoxy et OH.

14. Polymère selon la revendication 13, dans lequel le groupe R hydrolysable est un atome d'hydrogène.

15. Polymère selon la revendication 13, dans lequel le groupe R hydrolysable est un atome de chlore, de brome ou de fluor.

16. Polymère selon la revendication 9, dans lequel les motifs monomères sont dérivés au moins d'un 3,5-diméthyl-adamantyl-trichlorosilane ou d'un 3,5-diméthyl-adamantylsilane.

17. Composé selon la revendication 1, dans lequel un des groupes R est un groupe alkyle, alcényle, alcynyle ou aryle ayant, de préférence, de 1 à 10 atomes de carbone.

18. Composé selon la revendication 1, dans lequel deux des groupes R sont indépendamment choisis parmi les groupes alkyle, alcényle, alcynyle et aryle ayant, de préférence, de 1 à 10 atomes de carbone.

19. Composé selon les revendications 17 ou 18, dans lequel le groupe R est un groupe vinyle.

20. Composé selon les revendications 17 ou 18, dans lequel le groupe R est un groupe acétylène.

21. Composé de silane de formule II 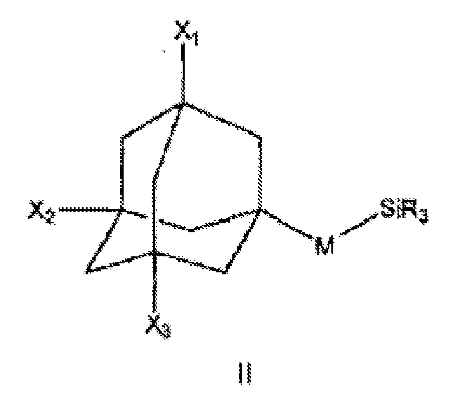 dans laquelle
X₁, X₂ et X₃ sont indépendamment choisis parmi un atome d'hydrogène et les groupes alkyle, alcényle et alcynyle ayant de 1 à 10 atomes de carbone éventuellement substitués,
à condition qu'au moins un des X₁, X₂ et X₃ soit un groupe alkyle, alcényle ou alcynyle,
M est un groupe alkylène ayant de 1 à 10 atomes de carbone,
chaque R représente indépendamment un groupe hydrolysable ou un groupe alkyle, alcényle, alcynyle ou aryle, au moins un des R représentant un atome d'halogène.

22. Composé de silane selon la revendication 21, dans lequel au moins un des R représente un groupe hydrolysable.

23. Composé selon la revendication 21, comprenant un 1,3,5-triméthyl-7-(trichlorosilylpropyl)-adamantane.

24. Polymère à basse constante diélectrique, capable de former un film mince ayant une constante diélectrique de 2,5 ou moins, comprenant des motifs monomères dérivés de précurseurs selon la formule II 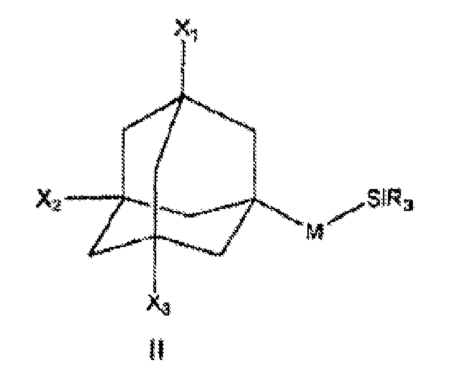 dans laquelle
X₁, X₂ et X₃ sont indépendamment choisis parmi un atome d'hydrogène et les groupes alkyle, alcényle et alcynyle ayant de 1 à 10 atomes de carbone éventuellement substitués,
à condition qu'au moins un des X₁, X₂ et X₃ soit un groupe alkyle, alcényle ou alcynyle,
M est un groupe alkylène ayant de 1 à 10 atomes de carbone,
chaque R représente indépendamment un groupe hydrolysable ou un groupe alkyle, alcényle, alcynyle ou aryle, au moins un des R étant un groupe hydrolysable.

25. Polymère à basse constante diélectrique, capable de former un film mince ayant une constante diélectrique de 2,5 ou moins, comprenant des motifs monomères dérivés de précurseurs selon les formules I et II, dans lequel pour la formule I :
X₁, X₂ et X₃ sont indépendamment choisis parmi un atome d'hydrogène, les groupes alkyle, alcényle et alcynyle ayant de 1 à 10 atomes de carbone éventuellement substitués,
à condition qu'au moins un des X₁, X₂ et X₃ soit autre qu'un atome d'hydrogène,
et,
chaque R représente indépendamment un groupe hydrolysable ou un groupe alkyle, alcényle, alcynyle ou aryle, au moins un des R étant un groupe hydrolysable
et
pour la formule II :
X₁, X₂ et X₃ sont indépendamment choisis parmi un atome d'hydrogène et les groupes alkyle, alcényle et alcynyle ayant de 1 à 10 atomes de carbone éventuellement substitués,
à condition qu'au moins un des X₁, X₂ et X₃ soit un groupe alkyle, alcényle ou alcynyle,
M est un groupe alkylène ayant de 1 à 10 atomes de carbone,
chaque R représente indépendamment un groupe hydrolysable ou un groupe alkyle, alcényle, alcynyle ou aryle, au moins un des R représentant un atome d'halogène.
